Europäisches Patentamt

European Patent Office

Office européen des brevets

(19)

(11) **EP 1 134 892 A1**

(12) **EUROPEAN PATENT APPLICATION**

(43) Date of publication:
**19.09.2001 Bulletin 2001/38**

(51) Int Cl.[7]: **H03H 17/06**

(21) Application number: **00104775.2**

(22) Date of filing: **06.03.2000**

(84) Designated Contracting States:
**AT BE CH CY DE DK ES FI FR GB GR IE IT LI LU MC NL PT SE**
Designated Extension States:
**AL LT LV MK RO SI**

(71) Applicant: **ROBERT BOSCH GMBH**
**70442 Stuttgart (DE)**

(72) Inventors:
• **Goeckler, Heinz**
  **71522 Backnang (DE)**
• **Groth, Alexandra**
  **44789 Bochum (DE)**

(54) **Digital filter structure**

(57)     In a block-processing approach to polyphase implementation of fractional sample rate conversion (FSRC) an extension to rational factors L/M with arbitrary L, M is provided. With a free choice of a factor F, a common integer factor of both M and L, adaption to any desired technology dependant clock rate is possible.

Fig. 10

**Description**

Field of the Invention and Description of the Prior Art

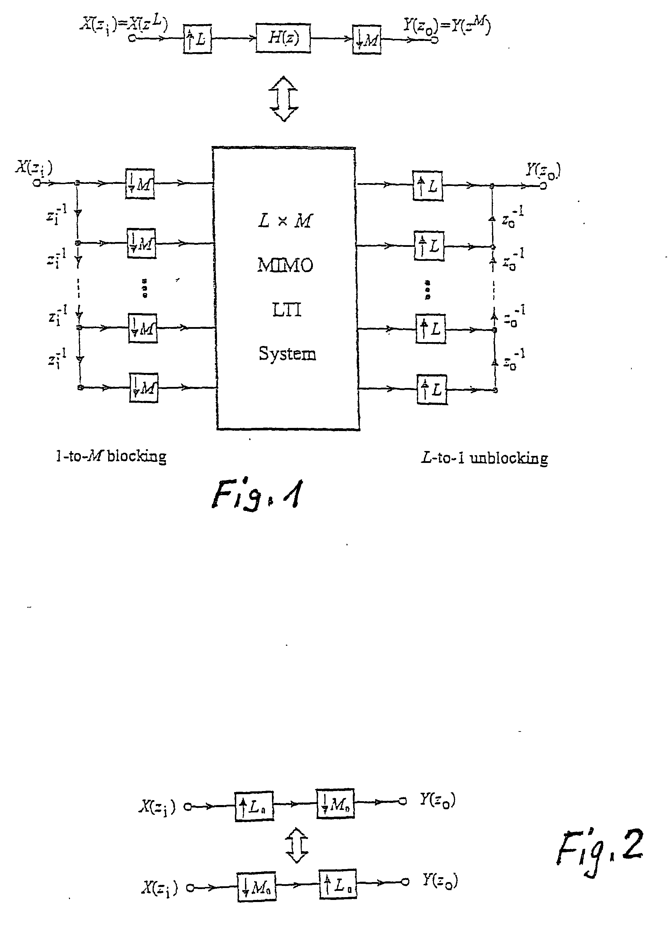

In digital filtering systems noninteger sample rate conversion performed by a fractional sample rate converter (FSRC) is one of the basic tasks. The system theoretic approach is a cascade connection of an L-fold upsampler, a filter H(z) and an M-fold downsampler (Fig. 1), where H(z) combines anti-imaging and anti-aliasing filtering. Recently, various derivations of FSRC have been published [1-3] under the constraint that the resampling factor R=L/M is represented by the ratio of two relatively prime positive integers. As a result, the block processing approach to FSRC according to Fig. 1 is obtained, where filtering is completely performed in the L * M MIMO LTI subsystem at a fixed subnyquist rate.

Summary of the Invention

In contrast to conventional filter structures with fractional sample rate conversion the filter structure according to the invention enables by free choice of F, a common integer factor of both M and L, to adapt the subnyquist operation rate $f_s = f_i/M = f_o/L$ of the FSRC system to any desired technology dependend clock rate.
With the invention according to claim 1 the conventional constraint of fractional sample rate conversion is no longer present according to the following assumption for the sample rate conversion factor R:

$$R = L/M = FL_o/(F * M_o) \; ; \; L, M, F, L_o, M_o \in N \tag{1}$$

where $L_o$ and $M_o$ are coprime. Important applications can, for instance, be found in parallel implementations of ultra high speed or wideband multirate systems, where the decimation factor $M_o$ of the specified resampling factor $R = L_o/M_o$ is not consistent with the speed limitations of the semiconductor technology to be applied.
Further embodiments of the invention can be found in the subclaims.

Brief Description of the Drawings

Embodiments of the invention are represented in the drawings and explained in more detail in the subsequent description.

Fig. 1 shows a transformation of system theoretic approach to block processing structure,
Fig. 2 shows the order reversal of up- and downsampler,
Fig. 3 shows three basic identities fo upsampling with subsequent delayed downsampling,
Fig. 4 shows steps to derive the novel identity for a first case a,
Fig. 5 shows a novel multirate identity for a second case b,
Fig. 6 shows the polyphase decomposition of output decimator of the system theoretic approach to FSRC (L ≥ M),
Fig. 7 shows the order reversal of upsampler and downsampler with zero-branches discarded,
Fig. 8 shows a rearrangement of the structure of Fig. 7,
Fig. 9 shows a polyphase implementation of FSRC and
Fig. 10 shows an example of a filter structure according to the invention.

Description of Embodiments

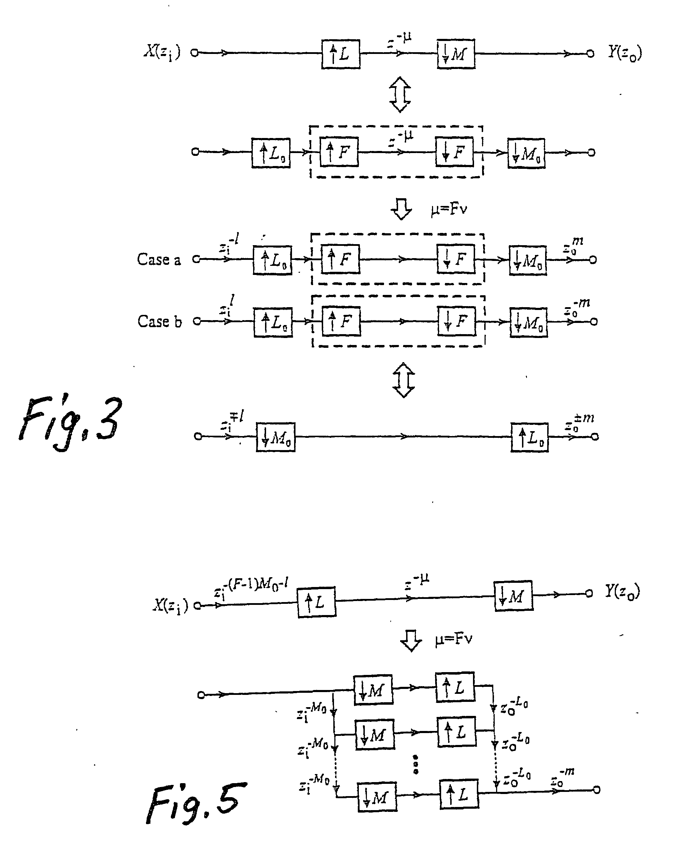

In the derivation procedure of the block processing approach to FSRC according to Fig. 1 with coprime L = $L_o$ and M = $M_o$, the noble identity [3] depicted in Fig. 2 has widely been used.
However, for unrestricted FSCR with L, M ∈ IN this noble identity is no longer applicable and, hence, must be generalized. To this end we start from a cascade connection of an up- and downsampler by L = $FL_o$ and M = $FM_o$, respectively, where downsampling is additionally delayed by μ time units with μ ∈ $IN_o$ as shown on top of Fig. 3.
From the original circuit of Fig. 3 a first identical structure is readily obtained by separating the common factor F from"L and M, respectively, in order to form a subsystem as indicated by the dashed box. According to [3] (application of polyphase identity) the output signal of such a subsystem is identically zero in case of μ ≠ Fv with v ∈ $N_o$. Hence, in the following we assume μ = Fv.
Considering the above restriction for μ, we decompose this integer by applying the Euler Theorem [3]

$$\mu = F\nu = lL - mM \text{ , Case a} \tag{2}$$

$$\mu = F\nu = mM - lL \text{ , Case b} \tag{3}$$

with $l, m \in \mathbb{IN}_o$. By introducing these substitutions into the structure of Fig. 3, the center delay can be split and allocated in part both at the input and the output of the structure, as depicted in Fig. 3. As a result of the application of some basic noble identities including that of Fig. 2, the structure depicted on bottom of Fig. 3 is obtained.

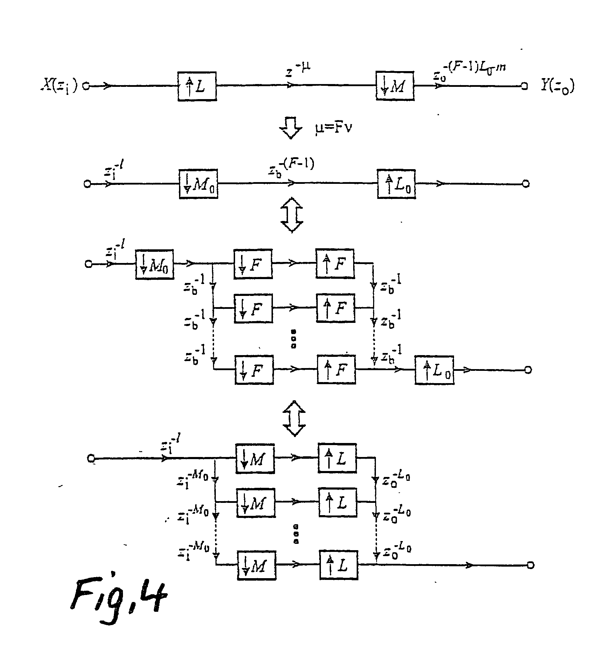

Next we introduce some extra delay in the original arrangement of Fig. 3, as shown in Fig. 4 for Case a. The output delay $Z_o^{-m}$ is required for feasibility of the second and third identity of Fig. 3. The reason for the output delay $Z_o^{-(F-1)Lo}$ will be explained soon. By replacing the cascade connection of upsampling by L and subsequent delayed downsampling by M of Fig. 4 (top) with the final identity of Fig. 3 (bottom), it is possible to shift the output delay $Z_o^{-(F-1)Lo}$ in front of the output upsampler by $L_o$ (first identity of Fig. 4). Note that $Z_b = Z_o^{Lo} = Z_t^{Mo}$.

In the next step (second identity of Fig. 4), the delay $Z_b^{-(F-1)}$ is equivalently substituted with a delay chain - perfect reconstruction (DC-PR) system [3] with F branches for down- and upsampling by F. By shifting the $M_o$-fold downsampler and the $L_o$-fold upsampler into each branch of the DC-PR system and subsequent combination with down- and upsampling by F, respectively, the finally desired structure is obtained (third identity of Fig. 4). Note that by the shifting operations the delay chains are now related to the input and output rates of the system, respectively.

In Case b the same derivation procedure can be applied yielding the identity depicted in Fig. 5. Here, in contrast to Case a an extra delay according to $Z_t^{-(F-1)Mo-1}$ has been added, where $Z_t^{-(F-1)Mo} = Z_o^{-(F-1)Mo-1}$.

For the development of the approach to unrestricted FSRC, we henceforth assume $L \geq M$ in order to be specific. To this end we decompose the cascade combination of H(z) with subsequent downsampling by M, the output decimator of the system theoretic approach to FSRC according to Fig. 1, into M polyphase components:

$$H(z) = \sum_{\mu=0}^{M-1} z^{-\mu} H_\mu(z^M) \tag{4}$$

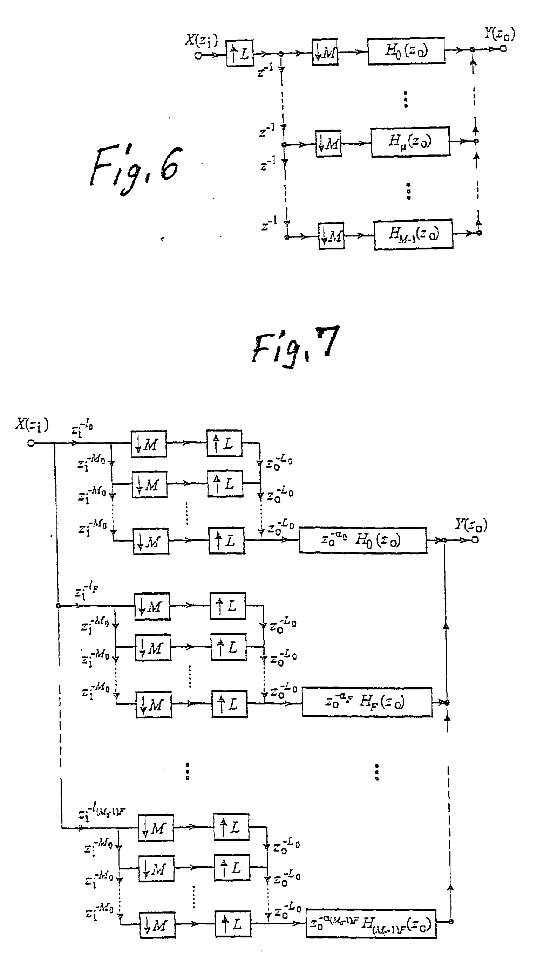

The resulting structure, obtained by exploiting a basic noble identity, is depicted in Fig. 6. We could also have decomposed the input interpolator of Fig. 1 into L polyphase components which, however, had been more suitable in case of L < M.

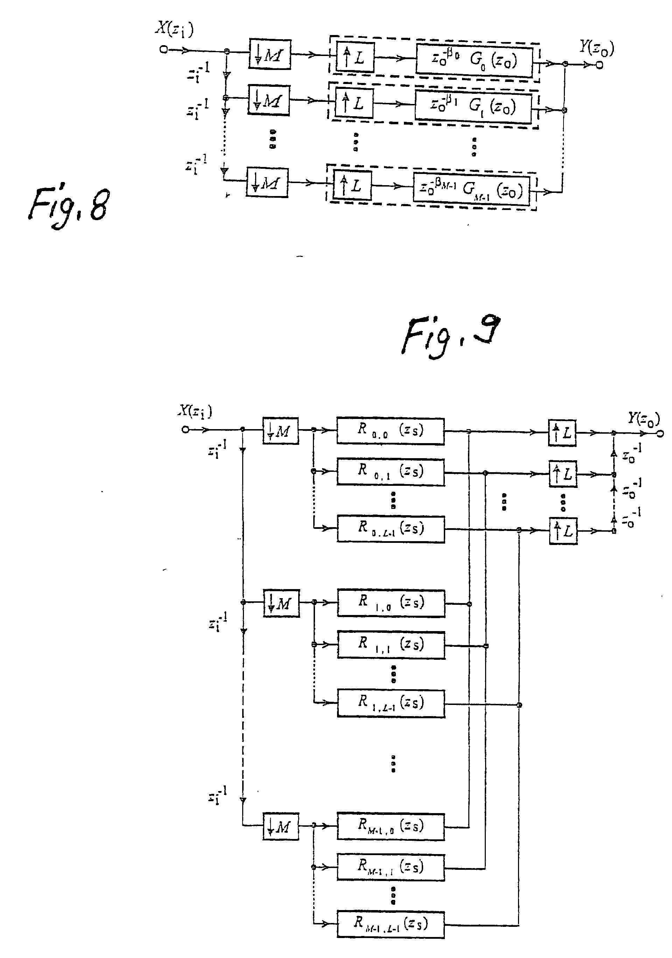

Our ultimate goal is to develop a block processing structure for FSRC as shown in Fig. 1. Therefore, the next intermediate step is to reverse the order of up- and downsamplers in Fig. 6. For this purpose upsampling by L and all delays of the delay chain are shifted into the M branches of the polyphase structure of Fig. 6. As a result, any branch $\mu$ comprises an upsampler followed by a $\mu$ time units delay $z^{-\mu}$, a downsampler and the branch filter $H_\mu(z_o)$. Next, those cascade combinations in front of the branch filters are replaced with the multirate identity according to Fig. 4, as shown in Fig. 7 (Obviously, $l_o = 0$).

It should be noted that, in Fig. 7, two features of the systems according to Fig. 4 have implicitly been exploited. The first property is due to the fact that for all $\mu \neq F\nu(\nu \in \mathbb{IN}_o, F \in \mathbb{IN}$: common factor of up- and downsampling) the transfer functions of the structures of Fig. 4 are identically zero. Hence only those branch filters with $\mu = F\nu$ are retained in Fig. 7. Secondly, by the above substitution some extra delay, $Z_o^{-(F-L)Lo}$ and $Z_o^{-m}$ is introduced. The former is identical for all $\mu$, wheras the latter depends on $\mu$, being subsequently accounted for by the substitutions m: = $m_\mu$ and l: = $l_\mu$, repectively in Eq.(2) and (3). However, in order to retain the FSRC system magnitude response, the overall delay introduced must be identical for all branches. For this reason, a branch dependent supplementary delay given by

$$z_o^{-\alpha_\mu} = z_o^{-\left\lfloor \frac{(M_0-1)L_0-1}{M_0} \right\rfloor} z_o^{m_\mu} \tag{5}$$

is combined with the branch filters, where $\mu = F\nu$. The first term of Eq.(5) represents the minimum additional delay for system realizability. Since this first term already comprises the delay $Z_o^m$ μ introduced by the novel identity (Fig. 4), it must be compensated for by the second term of Eq.(5).

For a third rearrangement step note that the structure of Fig. 7 represents an M-branch polyphase system, where obviously always F branches have a common branch filter ($M = FM_o$). Since $L_o$ and $M_o$ are coprime, $l_\mu$ assumes each value of the set $[0, ..., M_o - 1]$ for $\mu = F\nu$ and $\nu = 0, ..., M_o - 1$ (one-to-one mapping property of Euler Theorem). Hence, by suitably combining the delays $Z_t^{-1}$ μ with the delays $Z_t^{-Mo}$ of the Mo identical input delay chains of the novel F-branch identity of Fig. 4, the front end of the structure of Fig. 7 is rearranged to the familiar from of an M-branch input blocking circuit for decimation by M. In order to obtain the reordered system depicted in Fig. 8, in addition, the $M_o$ output branch filers of Fig. 7 are shifted into the respective paths of the novel F-branch multirate identity of Fig. 4. Using the branch index κ = 0, 1,...,M-1 the M branch filters are given by

$$G_\kappa(z_o) = H_{((\kappa)_{M_0} L)_M}(z_o) \quad , \tag{6}$$

where $(x)_y$ = x modulo y. Obviously, the modulo operation $(\kappa)_{Mo} = l_\mu$ reflects the fact that each branch filter is part of the overall system F times. Furthermore, according to Eq.(2) we have $\mu = (l_\mu L)_M = l_\mu L - m_\mu M$. Due to the output delay chains of the novel multirate identity the delay to be combined with the branch filters is increased according to

$$z_o^{-\beta_\kappa} = z_o^{-L_0(F-1-\lfloor \frac{\kappa}{M_0} \rfloor) - \alpha((\kappa)_{M_0} L)_M} \quad . \tag{7}$$

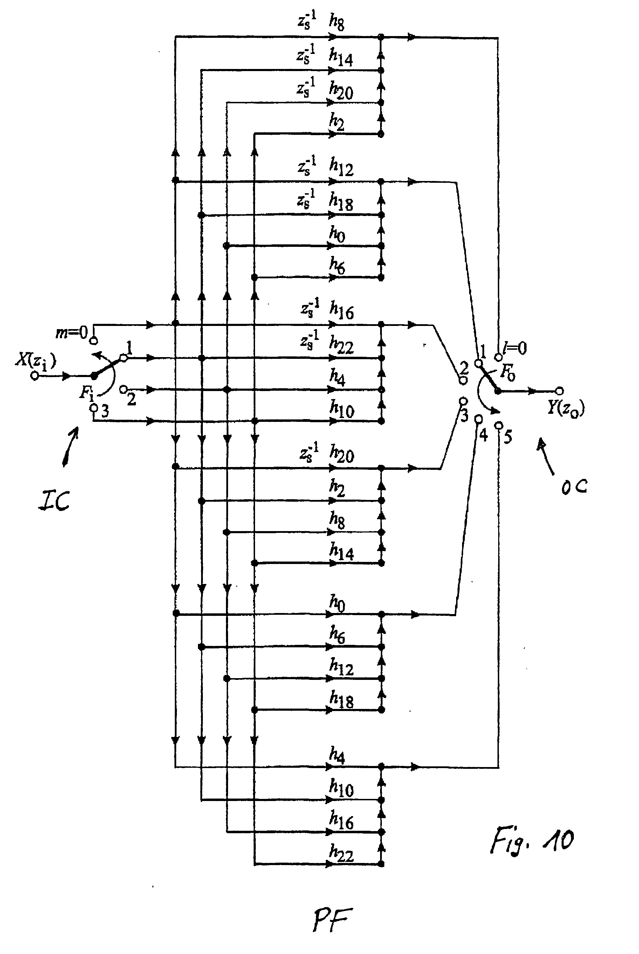

In the last step of rearrangement, the M output interpolators of Fig. 8 for sample rate increase by L (dashed blocks) are replaced by polyphase interpolators. As a result, we obtain M polyphase interpolators with identical output unblocking circuits, which are merged into one by means of elementary signal flow graph identities (Fig. 9). The resulting L * M branch filters are defined by

$$z_o^{-\beta_\kappa} G_\kappa(z_o) = \sum_{\tau=0}^{L-1} z_o^{-\tau} R_{\kappa\tau}(z_o^L) \quad , \tag{8}$$

where $Z_o^L = z_s$ corresponding to subnyquist processing at $f_s$.

In extension to conventional FSRC filtering a systematic z-domain based derivation of a minimal polyphase realization of fractional sample rate conversion by L/M with arbitrary L, M ∈ IN has been presented. Using a novel multirate identity, it has been shown that out of the M polyphase subfilters of the structure of Fig. 9 always F use the same coefficient subset of the original filter H(z), where F represents the common factor of L and M. However, due to the additional delay according to Eq.(7), the assignment of these coefficient subsets to the individual subfilters $R_{\kappa r}(z_S)$ is generally different.

In contrast to state of art processing, by free choice of F it is possible to adapt the subnyquist operation rate $f_s = f_i/M = f_o/L$ of the FSRC system to any desired technology dependent clock rate. Potential applications include parallelization of digital systems to any desired degree for minimum power consumption.

Fig. 10 showns as an example a digital filter structure according to the invention representing an interpolator with a sample rate conversation factor of R = 6/4 and an integer factor F = 2. The input commutator IC distributes the input signal $X_{(Zi)}$ on M(m = 0....3) filter branches with a sample rate Fi and the commutator 0C multiplexes L (I = 0...5) branches of filter signals to a common output signal $Y_{(Zo)}$ with a sample rate $F_o$. As each input filter branch is connected to each output filter branch there are M * L polyphase filter branches PF between the input (IC) and the output (OC) commutator.

The transfer functions of the M * L/F = 6 * 4/2 = 12 different polyphase branch filter components with oefficients of the impuls response h(o) - $h_{(23)}$ are present. As can be seen from Fig. 10 always F = 2 polyphase filter branch subfilters use the same coefficient subset.

<u>References</u>

[1] C.C. Hsiao, Polyphase Filter Matrix for Rational Sampling Rate Conversions, IEEE Int. Conf. Acoustics, Speech, Signal Processing ICASSP'87, Dallas, 1987, pp.2173-2176.

[2] H.G. Göckler, Method and Apparatus for the Transmission of Time Discrete Signals between Systems Operating at Different Sampling Rates, US Patent 4,725,972.

[3] P.P. Vaidyanathan, Multirate Systems and Filter Banks, Prentice Hall Signal Processing Series, 1993.

**Claims**

1. Digital filter structure comprising:

   - an input commutator (IC) for a number of M filter branches,
   - an output commutator (OC) for a number of L filter branches consisting of M filter branches each ,
   - a number of M * L polyphase branch filters (PF) between the input and the output commutator, having M * L/F different different polyphase branch filter components, with F beeing a freely selectable positive integer, determining M and L in such a way that F is a common integer factor of both M and L.

2. Digital filter structure according to claim 1, **characterized by** an upsampler as input sample rate converter (IC) and a downsampler as output sample rate converter (OC).

3. Digital filter structure according to claims 1 or 2 characteritzed by the filter structure beeing an interpolator with unrestricted polyphase fractional sample rate conversion with a fractional sample rate of e.g. 6/4.

4. Digital filter structure according to one of claims 1, 2 and 3 charaterized thereby, that the filter structure with respect to a conventional filter structure has proximately the same number of filter coefficients but has more identical filter components than said convential filter structure.

5. Digital filter structure according to one of claims 1 to 4 characterized thereby, that the filter structure is derived from a fractional sample rate converter with an input upsample rate conversion by a factor $L_o$ and an output down sample rate conversion by a factor $M_o$, with $L = L_oF$ and $M = M_oF$ ; $F \in$ IN.

6. Digital filter structure according to claim 5 characterized thereby, that the filter transfer function H(z) is decomposed with downsampling by M and that upsampling by L and all delays between the different filter branches are shifted into the M filter branches of a polyphase filter structure.

7. Digital filter structure according to claim 6 characterized thereby, that the up- and downsampling is reversed in their order.

8. Digital filter structure according to claim 7 characterized thereby, that the delays of the filter structure are rearranged and a branch dependent supplementary delay is combined with the filter branch delays.

9. Digital filter structure according to one of claims 7 or 8 characterized thereby, that the M output interpolators for sample rate increase by factor L are replaced by polyphase interpolators.

10. Digital filter structure according to one of claims 1 to 9 characterized thereby, that always F polyphase filter branch subfilters use the same coefficient subset.

$X(z_i) = X(z^L)$ $\uparrow L$ $H(z)$ $\downarrow M$ $Y(z_0) = Y(z^M)$

$X(z_i)$

$z_i^{-1}$

$z_i^{-1}$

$z_i^{-1}$

$z_i^{-1}$

$\downarrow M$

$\downarrow M$

$\downarrow M$

$\downarrow M$

$L \times M$

MIMO

LTI

System

$\uparrow L$

$\uparrow L$

$\uparrow L$

$\uparrow L$

$Y(z_0)$

$z_0^{-1}$

$z_0^{-1}$

$z_0^{-1}$

$z_0^{-1}$

1-to-$M$ blocking

$L$-to-1 unblocking

Fig.1

$X(z_i)$ ○→ $\uparrow L_0$ → $\downarrow M_0$ →○ $Y(z_0)$

$X(z_i)$ ○→ $\downarrow M_0$ → $\uparrow L_0$ →○ $Y(z_0)$

Fig.2

6

Fig.3

Fig.5

$X(z_i) \circ \longrightarrow \boxed{\uparrow L} \xrightarrow{\quad z^{-\mu} \quad} \boxed{\downarrow M} \xrightarrow{\quad z_0^{-(F-1)L_0 \cdot m} \quad} \circ Y(z_0)$

$\Downarrow \quad \mu = Fv$

$\circ \xrightarrow{\; z_i^{-l} \;} \boxed{\downarrow M_0} \xrightarrow{\; z_b^{-(F-1)} \;} \boxed{\uparrow L_0} \longrightarrow \circ$

$\Updownarrow$

$\circ \xrightarrow{\; z_i^{-l} \;} \boxed{\downarrow M_0} \longrightarrow \boxed{\downarrow F} \longrightarrow \boxed{\uparrow F} \;\; z_b^{-1}$

$z_b^{-1} \; \boxed{\downarrow F} \longrightarrow \boxed{\uparrow F} \;\; z_b^{-1}$

$z_b^{-1} \; \boxed{\downarrow F} \longrightarrow \boxed{\uparrow F} \;\; z_b^{-1} \; \boxed{\uparrow L_0} \longrightarrow \circ$

$\Updownarrow$

$\circ \xrightarrow{\; z_i^{-l} \;} \boxed{\downarrow M} \longrightarrow \boxed{\uparrow L} \;\; z_0^{-L_0}$

$z_i^{-M_0} \; \boxed{\downarrow M} \longrightarrow \boxed{\uparrow L} \;\; z_0^{-L_0}$

$z_i^{-M_0} \; \boxed{\downarrow M} \longrightarrow \boxed{\uparrow L} \;\; z_0^{-L_0} \longrightarrow \circ$

**Fig. 4**

Fig. 6

Fig. 7

$Fig. 8$

$Fig. 9$

Fig. 10

European Patent
Office

**EUROPEAN SEARCH REPORT**

Application Number

EP 00 10 4775

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | US 4 725 972 A (GOECKLER HEINZ) 16 February 1988 (1988-02-16) * column 3, line 13 - column 6, line 11; figure 3 * --- | 1-3,10 | H03H17/06 |
| D,A | CHIA-CHUAN HSIAO: "Polyphase Filter Matrix for Rational Sampling Rate Conversions" PROCEEDINGS OF THE INTERNATIONAL CONFERENCE ON ACOUSTICS, SPEECH, AND SIGNAL PROCESSING (ICASSP), vol. 4, April 1987 (1987-04), pages 2173-2176, XP000925119 US, New York * the whole document * --- | 1-3,10 | |
| A | YIM W ET AL: "POLYPHASE MATRIX AND LATTICE DECOMPOSITION FOR MULTIRATE FILTERS AND FILTER BANKS" PROCEEDINGS OF THE INTERNATIONAL CONFERENCE ON ACOUSTICS, SPEECH AND SIGNAL PROCESSING (ICASSP),US,NEW YORK, IEEE, vol. CONF. 17, 23 March 1992 (1992-03-23), pages IV-625-IV-627, XP000467272 ISBN: 0-7803-0532-9 * paragraph [0002] * * paragraph [0003] * * figure 1 * --- | 1-3,10 | TECHNICAL FIELDS SEARCHED (Int.Cl.7) H03H |

-/--

The present search report has been drawn up for all claims

| Place of search | Date of completion of the search | Examiner |
|---|---|---|
| THE HAGUE | 7 August 2000 | D/L PINTA BALLE.., L |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**European Patent Office**

# EUROPEAN SEARCH REPORT

Application Number

EP 00 10 4775

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | BI G ET AL: "RATIONAL SAMPLING RATE CONVERSION STRUCTURES WITH MINIMUM DELAY REQUIREMENTS" IEE PROCEEDINGS E. COMPUTERS & DIGITAL TECHNIQUES,GB,INSTITUTION OF ELECTRICAL ENGINEERS. STEVENAGE, vol. 139, no. 6 PART E, 1 November 1992 (1992-11-01), pages 477-485, XP000331211 ISSN: 1350-2387 * paragraph [0004] * * paragraph [0006] * * figures 5,6,9 * ----- | 1-3,10 | |
| | | | **TECHNICAL FIELDS SEARCHED** (Int.Cl.7) |

The present search report has been drawn up for all claims

| Place of search | Date of completion of the search | Examiner |
|---|---|---|
| THE HAGUE | 7 August 2000 | D/L PINTA BALLE.., L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 00 10 4775

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2000

| Patent document cited in search report | Publication date | Patent family member(s) | Publication date |
|---|---|---|---|
| US 4725972 A | 16-02-1988 | EP 0131641 A<br>AT 37972 T<br>CA 1261084 A<br>DE 3378245 D | 23-01-1985<br>15-10-1988<br>26-09-1989<br>17-11-1988 |

EPO FORM P0459

For more details about this annex : see Official Journal of the European Patent Office, No. 12/82